# EUROPÄISCHE PATENTANMELDUNG

(11) **EP 4 756 463 A1**
(43) Veröffentlichungstag der Anmeldung: **10.06.2026**
(21) Anmeldenummer: 24850657.8
(22) Anmeldetag: 06.06.2024
(51) Int. Cl.: G01R 31/52

(54) **KURZSCHLUSSFEHLERERKENNUNGSSYSTEM UND -VERFAHREN**

(30) Priorität: 04.08.2023 CN 202310981816
(71) Anmelder: Schaeffler Technologies AG & Co. KG, 91074 Herzogenaurach (DE)
(72) Erfinder: ZHANG, Xiaoliang, Shanghai 201804 (CN)
(74) Vertreter: Schaeffler Technologies
(86) Internationale Anmeldenummer: PCT/CN2024/097656
(87) Internationale Veröffentlichungsnummer: WO 2025/031005

(57) **Zusammenfassung**

Ausführungsbeispiele der vorliegenden Anmeldung stellen ein Kurzschlussfehlererkennungssystem und -verfahren bereit. Das Kurzschlussfehlererkennungssystem umfasst: ein Versorgungsmodul, das zum Versorgen des Erkennungssystems mit Strom dient; ein Ansteuermodul, das mit dem Versorgungsmodul und einem Motor gekoppelt ist und dazu dient, eine vom Versorgungsmodul bereitgestellte Systemspannung in eine Spannung umzuwandeln, mit der der Motor betrieben wird; ein Stromabtastmodul, das mit dem Ansteuermodul gekoppelt ist und dazu dient, den Phasenstrom des Motors abzutasten; sowie ein Fehlererkennungsmodul, das mit dem Versorgungsmodul und dem Stromabtastmodul gekoppelt ist, wobei das Fehlererkennungsmodul dazu konfiguriert ist: eine Phasenspannung zu erfassen, die dem Phasenstrom des Motors entspricht, und basierend auf der Phasenspannung einen Initialisierungs-Selbsttest des Erkennungssystems durchzuführen.

## Beschreibung

### Querverweis auf verwandte Anmeldungen

Diese Anmeldung beansprucht die Priorität der chinesischen Patentanmeldung Nr. 202310981816.6 mit dem Titel "Kurzschlussfehlererkennungssystem und -verfahren", eingereicht am 4. August 2023, deren gesamter Inhalt durch Bezugnahme hierin aufgenommen wird.

### Technisches Gebiet

Die vorliegende Anmeldung betrifft das Gebiet der integrierten Schaltungen, genauer gesagt, ein Kurzschlussfehlererkennungssystem und -verfahren.

### Stand der Technik

In Dreiphasen-Motorsteuerungssystemen werden üblicherweise Phasenleitungsschalter an den Phasenleitungen des Motors als Anwendung zum Phasenausfallschutz des Motors eingesetzt. Bei Anwendungsdesigns, die MOSFETs als Phasenleitungsschalter verwenden, können bei den MOSFETs zufällige Hardwarefehler auftreten, beispielsweise Unterbrechungsfehler, Kurzschlussfehler usw. Wenn ein Phasenleitungs-MOSFET-Schalter ausfällt, führt dies zum Versagen der Schalterfunktion und beeinträchtigt die Steuerung des Motors. Unterbrechungsfehler von MOSFETs können diagnostiziert werden, während das Steuerungssystem in Echtzeit läuft. Kurzschlussfehler von MOSFETs können nicht diagnostiziert werden, während das Steuerungssystem in Echtzeit läuft, sondern müssen während des Ein-/Ausschalt-Selbsttestprozesses des Steuerungssystems diagnostiziert werden, um solche Fehler zu erkennen.

In Dreiphasen-Motorsteuerungssystemen, die gleichzeitig Phasenleitungs-MOSFET-Schalter und High-Side-MOSFET-Schalter verwenden, muss der Ladungspumpenausgang genutzt werden, damit der High-Side-MOSFET-Schalter einen geschlossenen Stromkreis bildet, und es muss anhand dessen, ob in dem geschlossenen Stromkreis ein Strom erzeugt wird, bestimmt werden, ob ein Kurzschlussfehler des Phasenleitungs-MOSFET-Schalters aufgetreten ist. Daher wird ein strukturell einfaches und hocheffizientes Kurzschlussfehlererkennungssystem benötigt.

### Inhalt der Erfindung

Ausführungsbeispiele der vorliegenden Anmeldung stellen ein Kurzschlussfehlererkennungssystem bereit, umfassend: ein Versorgungsmodul, das zum Versorgen des Erkennungssystems mit Strom dient; ein Ansteuermodul, das mit dem Versorgungsmodul und einem Motor gekoppelt ist und dazu dient, eine vom Versorgungsmodul bereitgestellte Systemspannung in eine Spannung umzuwandeln, mit der der Motor betrieben wird; ein Stromabtastmodul, das mit dem Ansteuermodul gekoppelt ist und dazu dient, den Phasenstrom des Motors abzutasten; sowie ein Fehlererkennungsmodul, das mit dem Versorgungsmodul und dem Stromabtastmodul gekoppelt ist, wobei das Fehlererkennungsmodul dazu konfiguriert ist: eine Phasenspannung zu erfassen, die dem Phasenstrom des Motors entspricht, und basierend auf der Phasenspannung einen Initialisierungs-Selbsttest des Erkennungssystems durchzuführen.

Ausführungsbeispiele der vorliegenden Anmeldung stellen ein Kurzschlussfehlererkennungsverfahren für ein Kurzschlussfehlererkennungssystem bereit, wobei das Erkennungssystem ein Versorgungsmodul, ein Ansteuermodul, ein Stromabtastmodul und ein Fehlererkennungsmodul umfasst, wobei das Erkennungsverfahren umfasst: Versorgen des Erkennungssystems mit Strom durch das Versorgungsmodul; Umwandeln einer vom Versorgungsmodul bereitgestellten Systemspannung in eine Spannung, mit der der Motor betrieben wird, durch das Ansteuermodul; Abtasten des Phasenstroms des Motors durch das Stromabtastmodul; sowie Erfassen einer Phasenspannung, die dem Phasenstrom des Motors entspricht, durch das Fehlererkennungsmodul, und Durchführen eines Initialisierungs-Selbsttests des Erkennungssystems basierend auf der Phasenspannung.

### Kurze Beschreibung der Zeichnungen

Um die technischen Lösungen der Ausführungsbeispiele der vorliegenden Anmeldung klarer zu erläutern, werden im Folgenden die Zeichnungen, die die Ausführungsbeispiele der vorliegenden Anmeldung betreffen, kurz beschrieben. Für den Fachmann auf diesem Gebiet sind auf der Grundlage dieser Zeichnungen weitere Zeichnungen ableitbar, ohne dass dafür schöpferischer Aufwand erforderlich ist. In den Zeichnungen zeigt:
Fig. 1 ein schematisches Strukturdiagramm eines MOSFET-Kurzschlussfehlererkennungssystems für eine Dreiphasen-Brückenwechselrichterschaltung;
Fig. 2 ein schematisches Strukturdiagramm eines Kurzschlussfehlererkennungssystems gemäß einem Ausführungsbeispiel der vorliegenden Anmeldung;
Fig. 3 ein weiteres schematisches Strukturdiagramm eines Kurzschlussfehlererkennungssystems gemäß einem Ausführungsbeispiel der vorliegenden Anmeldung;
Fig. 4 ein schematisches Flussdiagramm eines Kurzschlussfehlererkennungsverfahrens gemäß einem Ausführungsbeispiel der vorliegenden Anmeldung; und
Fig. 5 ein weiteres schematisches Flussdiagramm eines Kurzschlussfehlererkennungsverfahrens gemäß einem Ausführungsbeispiel der vorliegenden Anmeldung.

### Ausführungsformen

Nachfolgend werden die Merkmale und beispielhaften Ausführungsformen der verschiedenen Aspekte der vorliegenden Anmeldung detailliert beschrieben. Um die Zwecke, Lösungen und Vorteile der vorliegenden Anmeldung klarer zu machen, werden die Details der vorliegenden Anmeldung im Folgenden in Verbindung mit den Zeichnungen und spezifischen Ausführungsbeispielen weiter detailliert beschrieben. Es versteht sich, dass die hierin beschriebenen spezifischen Ausführungsbeispiele nur zur Erläuterung der vorliegenden Anmeldung dienen und nicht dazu gedacht sind, die vorliegende Anmeldung einzuschränken. Für den Fachmann auf diesem Gebiet kann die vorliegende Anmeldung ohne einige dieser spezifischen Details implementiert werden. Die folgende Beschreibung der Ausführungsbeispiele dient lediglich dazu, ein besseres Verständnis der vorliegenden Anmeldung durch die Darstellung von Beispielen der vorliegenden Anmeldung zu vermitteln.

Es ist zu beachten, dass in diesem Text relationale Begriffe wie "erste/r/s", "zweite/r/s", "dritte/r/s" usw. nur dazu verwendet werden, eine Entität oder einen Vorgang von einer anderen Entität oder einem Vorgang zu unterscheiden, und nicht notwendigerweise eine tatsächliche Beziehung oder Reihenfolge zwischen diesen Entitäten oder Vorgängen erfordern oder implizieren. Des Weiteren sollen die Begriffe "umfassen", "beinhalten" und jede andere Variante davon eine nicht-ausschließliche Einbeziehung abdecken, und ein Prozess, ein Verfahren, ein Gegenstand oder eine Vorrichtung, die eine Reihe von Elementen umfasst, umfasst nicht nur diese Elemente, sondern auch andere nicht ausdrücklich aufgeführte Elemente oder Elemente, die für einen solchen Prozess, ein solches Verfahren, einen solchen Gegenstand oder eine solche Vorrichtung inhärent sind. Ohne weitere Einschränkungen schließt ein Element, das durch den Satz "umfasst ein/e..." definiert wird, nicht aus, dass in dem Prozess, dem Verfahren, dem Gegenstand oder der Vorrichtung, die das Element umfasst, zusätzliche Elemente vorhanden sind.

Wie bereits erwähnt, können MOSFET-Kurzschlussfehler nicht diagnostiziert werden, während das Steuerungssystem in Echtzeit läuft, sondern müssen während des Ein-/Ausschalt-Selbsttestprozesses des Steuerungssystems diagnostiziert werden. Für den Einschalt-Selbsttest eines N-Kanal-MOSFETs muss sichergestellt werden, dass am Drain (D-Anschluss) des MOSFETs die Versorgungsspannung anliegt und am Gate (G-Anschluss) des MOSFETs eine Ladungspumpenspannung anliegt, die höher als die am D-Anschluss ist.

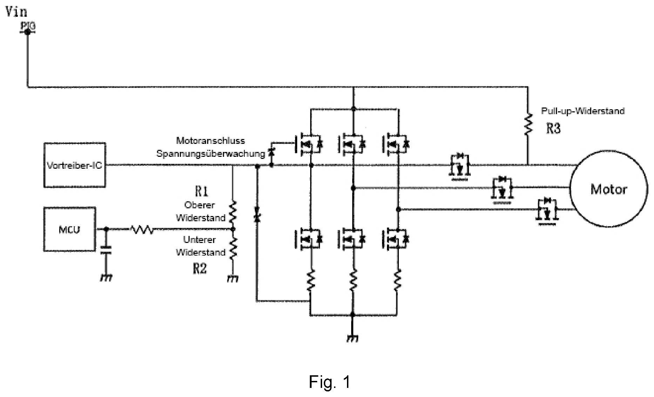

Fig. 1 zeigt ein schematisches Strukturdiagramm eines MOSFET-Kurzschlussfehlererkennungssystems für eine Dreiphasen-Brückenwechselrichterschaltung nach dem Stand der Technik.

Wie in Fig. 1 gezeigt, umfasst das MOSFET-Kurzschlussfehlererkennungssystem ein MCU-Modul, einen Vortreiber-IC, eine Dreiphasen-Brückenansteuerschaltung, Phasenleitungs-MOSFET-Schalter, einen Pull-up-Widerstand R3 und eine Spannungsteilerschaltung usw., wobei das MCU-Modul die Motoranschlussspannung über die Spannungsteilerschaltung überwacht, wobei die AD-Abtastung durch einen ADC innerhalb des MCU-Moduls erfolgt, und die Spannungsteilerschaltung aus einem oberen Spannungsteilerwiderstand R1 und einem unteren Spannungsteilerwiderstand R2 besteht, die in Reihe geschaltet sind.

In diesem MOSFET-Kurzschlussfehlererkennungssystem ist eine einzelne Phase des Motors über den Pull-up-Widerstand R3 mit der Eingangsversorgung verbunden. Wenn beispielsweise ein Kurzschlussfehler des Phasenleitungs-MOSFET-Schalters auftritt, fließt der Versorgungsstrom über den Pull-up-Widerstand R3 durch die Motorspule und den kurzgeschlossenen MOSFET und erzeugt eine Spannung an der Spannungsteilerschaltung, wodurch der MOSFET-Kurzschlussfehler erkannt wird.

Dieses Erkennungssystem weist die folgenden Nachteile auf. Erstens ist die Schaltungsstruktur komplex, was die Schaltungs- und Ressourcenkosten erhöht. Insbesondere werden in diesem Erkennungssystem zusätzlich zu den Bauteilen, die den normalen Betrieb der Schaltung gewährleisten, drei Widerstände R1, R2 und R3 hinzugefügt, und zusätzlich zu den Ressourcen, die den normalen Betrieb der Schaltung gewährleisten, wird ein ADC-Port hinzugefügt. Zweitens wird ein zusätzliches Kurzschlussfehlerdiagnoseprogramm hinzugefügt, was die Softwarekosten erhöht. Beispielsweise muss der zusätzliche ADC-Port des MCU-Moduls die Echtzeitspannung des Motoranschlusses überwachen. Wenn diese Echtzeitspannung in einem bestimmten Bereich liegt, wird bestimmt, dass das System normal funktioniert; wenn diese Echtzeitspannung in einem anderen Bereich liegt, wird bestimmt, dass ein Kurzschlussfehler des Phasenleitungs-MOSFET-Schalters aufgetreten ist. Daher muss die Systemsoftware für verschiedene Spannungsbereiche separate Beurteilungen durchführen, und das Festlegen unterschiedlicher Spannungsbereichswerte erhöht ebenfalls den Softwareaufwand.

Mit Bezug auf Dreiphasen-Motorsteuerungssysteme, die gleichzeitig Phasenleitungs-MOSFET-Schalter und High-Side-MOSFET-Schalter verwenden, stellt die vorliegende Anmeldung ein Erkennungssystem zum Erkennen von Kurzschlussfehlern der Phasenleitungs-MOSFET-Schalter bereit. Das Erkennungssystem gemäß den Ausführungsbeispielen der vorliegenden Anmeldung kann Kurzschlussfehler von Phasenleitungs-MOSFET-Schaltern erkennen, ohne zusätzliche Schaltungskosten und zusätzlichen Softwareaufwand zu verursachen, einen Initialisierungs-Selbsttest des Erkennungssystems durchführen und in den normalen Betriebsmodus zur Steuerung des Motors übergehen, während gleichzeitig auch die Steuerung der High-Side-MOSFET-Schalter realisiert werden kann.

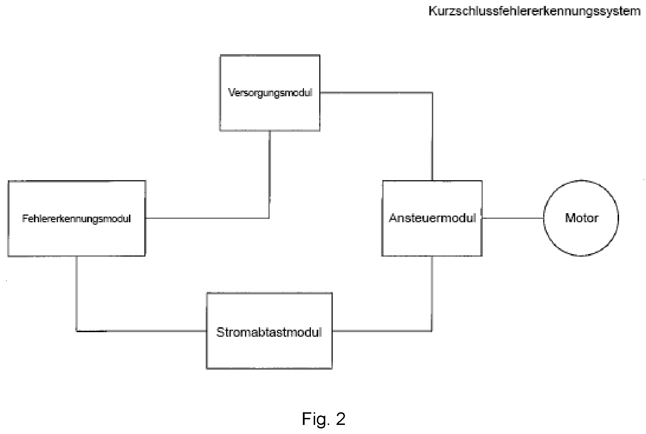

Nun werden die Ausführungsbeispiele der vorliegenden Anmeldung unter Bezugnahme auf die Zeichnungen beschrieben. Bezugnehmend auf Fig. 2 wird ein schematisches Strukturdiagramm eines Kurzschlussfehlererkennungssystems gemäß einem Ausführungsbeispiel der vorliegenden Anmeldung gezeigt. Dieses Erkennungssystem kann zur Kurzschlussfehlererkennung in Dreiphasen-Motorsteuerungssystemen verwendet werden, die sowohl Phasenleitungs-MOSFET-Schalter als auch High-Side-MOSFET-Schalter verwenden.

Wie in Fig. 2 gezeigt, umfasst das Kurzschlussfehlererkennungssystem gemäß einigen Ausführungsbeispielen der vorliegenden Anmeldung ein Versorgungsmodul, ein Ansteuermodul, ein Stromabtastmodul sowie ein Fehlererkennungsmodul.

In einigen Ausführungsbeispielen kann das Versorgungsmodul dazu dienen, das Erkennungssystem mit Strom zu versorgen. Das Ansteuermodul kann mit dem Versorgungsmodul und dem Motor (z. B. einem bürstenlosen Dreiphasenmotor usw.) gekoppelt sein und dazu dienen, eine vom Versorgungsmodul bereitgestellte Systemspannung in eine Spannung umzuwandeln, mit der der Motor betrieben wird. Das Stromabtastmodul kann mit dem Ansteuermodul gekoppelt sein und dazu dienen, den Phasenstrom des Motors abzutasten. Des Weiteren kann in einigen Ausführungsbeispielen das Fehlererkennungsmodul mit dem Versorgungsmodul und dem Stromabtastmodul gekoppelt sein, wobei das Fehlererkennungsmodul dazu konfiguriert sein kann, eine Phasenspannung zu erfassen, die dem Phasenstrom des Motors entspricht, und basierend auf der Phasenspannung einen Initialisierungs-Selbsttest des Erkennungssystems durchzuführen.

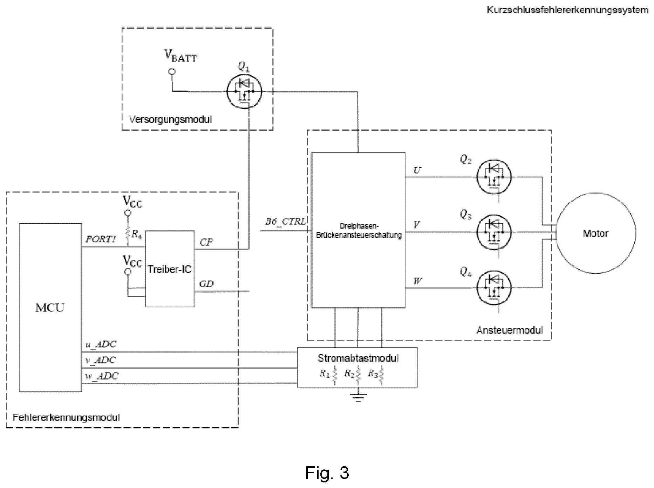

Bezugnehmend auf Fig. 3 wird ein weiteres schematisches Strukturdiagramm eines Kurzschlussfehlererkennungssystems gemäß einem Ausführungsbeispiel der vorliegenden Anmeldung gezeigt.

In einigen Ausführungsbeispielen kann, wie in Fig. 3 gezeigt, das Fehlererkennungsmodul in diesem Erkennungssystem eine Mikrocontrollereinheit MCU umfassen, und das Fehlererkennungsmodul kann ferner dazu konfiguriert sein, den Initialisierungs-Selbsttest des Erkennungssystems durch Konfigurieren des Zustands des Ports PORT1 der Mikrocontrollereinheit MCU durchzuführen. Optional kann dieser Port PORT1 ein Eingabe-/Ausgabeport der Mikrocontrollereinheit MCU sein und als Eingabe und/oder Ausgabe der Mikrocontrollereinheit MCU verwendet werden. In einigen Ausführungsbeispielen kann das Konfigurieren des Zustands des Ports PORT1 das Konfigurieren des Ports PORT1 in einen von einem Low-Pegel-Ausgangszustand und einem hochohmigen Eingangszustand umfassen.

Des Weiteren kann in einigen Ausführungsbeispielen, wie in Fig. 3 gezeigt, die Mikrocontrollereinheit MCU über ihre ADC-Eingangsports u_ADC, v_ADC, w_ADC mit dem Stromabtastmodul gekoppelt sein, um die Phasenspannung zu erfassen, die dem vom Stromabtastmodul abgetasteten Phasenstrom des Motors entspricht.

Insbesondere kann die Mikrocontrollereinheit MCU über die ADC-Eingangsports u_ADC, v_ADC, w_ADC die Spannungssignale erfassen, die erhalten werden, nachdem die Ströme der verschiedenen Phasenleitungen des Motors (z. B. Dreiphasenstrom) durch die Stromabtastwiderstände im Stromabtastmodul geflossen sind und einer Modulationsverarbeitung unterzogen wurden, und basierend auf den Spannungssignalen die Stärke des Phasenstroms beurteilen. Beispielsweise, wenn auf der Phasenleitung kein Stromkreis gebildet wird (d. h. auf dieser Phasenleitung ist kein Kurzschlussfehler aufgetreten), ist das von der Mikrocontrollereinheit MCU erfasste ADC-Abtastspannungssignal, das dieser Phasenleitung entspricht, Null, während, wenn auf der Phasenleitung ein Stromkreis gebildet wird (d. h. auf dieser Phasenleitung ist ein Kurzschlussfehler aufgetreten), das entsprechende ADC-Abtastspannungssignal ein voreingestellter Wert ist. Es ist zu beachten, dass der voreingestellte Wert dieses Spannungssignals in der vorliegenden Anmeldung basierend auf der spezifischen Schaltungsstruktur festgelegt werden kann und hier nicht eingeschränkt ist.

In einigen Ausführungsbeispielen kann, wie in Fig. 3 gezeigt, das Fehlererkennungsmodul ferner einen Treiber-IC (integrierten Schaltkreis) umfassen, und die oben genannte Mikrocontrollereinheit MCU kann dazu konfiguriert sein, über den Port PORT1 mit dem Treiber-IC gekoppelt zu sein und über den Port PORT1 den Ausgangszustand des Treiber-ICs zu steuern.

In einigen Ausführungsbeispielen kann der Treiber-IC einen Ladungspumpen-Spannungsausgangsanschluss CP und einen Gate-Ansteuerungs-Spannungsausgangsanschluss GD umfassen, und das Steuern des Ausgangszustands des Treiber-ICs über den Port PORT1 kann umfassen: wenn der Port PORT1 in den Low-Pegel-Ausgangszustand konfiguriert ist, Aktivieren des Ladungspumpen-Spannungsausgangsanschlusses CP und Deaktivieren des Gate-Ansteuerungs-Spannungsausgangsanschlusses GD; und wenn der Port PORT1 als hochohmiger Eingangszustand konfiguriert ist, Aktivieren sowohl des Ladungspumpen-Spannungsausgangsanschlusses CP als auch des Gate-Ansteuerungs-Spannungsausgangsanschlusses GD.

In einigen Ausführungsbeispielen kann, wie in Fig. 3 gezeigt, das Versorgungsmodul eine Systemstromversorgung V_{BATT} und einen ersten Transistor Q1 umfassen, und das Fehlererkennungsmodul und das Ansteuermodul können über den ersten Transistor Q1 mit der Systemstromversorgung V_{BATT} gekoppelt sein.

In der vorliegenden Anmeldung ist die Systemstromversorgung V_{BATT} die Stromversorgung für das System, die dazu dient, das Erkennungssystem mit Strom zu versorgen und die Systemspannung bereitzustellen. Des Weiteren kann das Erkennungssystem gemäß den Ausführungsbeispielen der vorliegenden Anmeldung auch eine Chip-Versorgungsspannung Vcc umfassen, die dazu dient, die Mikrocontrollereinheit MCU und den Treiber-IC im Erkennungssystem usw. mit Strom zu versorgen. Des Weiteren kann in der vorliegenden Anmeldung der erste Transistor Q1 ein Metall-Oxid-Halbleiter-Feldeffekttransistor (MOSFET) oder jeder andere Typ von Transistor sein und als High-Side-MOSFET-Schalter des Erkennungssystems verwendet werden. Es ist zu beachten, dass die vorliegende Anmeldung keine Einschränkungen hinsichtlich der spezifischen Struktur und Parameter des ersten Transistors Q1 macht.

In einigen Ausführungsbeispielen kann das Fehlererkennungsmodul ferner dazu konfiguriert sein: durch Konfigurieren des Zustands des Ports PORT1 der Mikrocontrollereinheit MCU das Leiten und Sperren des ersten Transistors Q1 zu steuern. Optional kann in einigen Ausführungsbeispielen der erste Transistor Q1 leiten, wenn der Port PORT1 in den Low-Pegel-Ausgangszustand oder als hochohmiger Eingangszustand konfiguriert ist.

In einigen Ausführungsbeispielen kann, wie in Fig. 3 gezeigt, das Ansteuermodul eine Dreiphasen-Brückenansteuerschaltung umfassen, die von einem Ansteuersignal (in Fig. 3 als B6_CTRL gezeigt) angesteuert wird. Beispielsweise kann dieses Ansteuersignal B6_CTRL ein PWM-Ansteuersignal von der Mikrocontrollereinheit MCU sein, das dazu dient, die Schalter in den Brückenarmen der Dreiphasen-Brückenansteuerschaltung anzusteuern, um den Motorbetrieb zu steuern. Es ist zu beachten, dass die vorliegende Anmeldung keine Einschränkungen hinsichtlich der spezifischen Struktur und Parameter der Dreiphasen-Brückenansteuerschaltung macht; jede Form einer Dreiphasen-Brückenansteuerschaltung kann in der vorliegenden Anmeldung angewendet werden. Des Weiteren macht die vorliegende Anmeldung auch keine spezifischen Einschränkungen hinsichtlich der Form und Parameter des PWM-Ansteuersignals, das für die Dreiphasen-Brückenansteuerschaltung verwendet wird.

In einigen Ausführungsbeispielen kann das Ansteuermodul ferner einen zweiten Transistor Q2, einen dritten Transistor Q3 und einen vierten Transistor Q4 umfassen, und wobei der zweite Transistor Q2, der dritte Transistor Q3 und der vierte Transistor Q4 jeweils mit der Dreiphasen-Brückenansteuerschaltung sowie verschiedenen Phasenleitungen des Motors gekoppelt sein können.

Wie in Fig. 3 gezeigt, sind die Dreiphasen-Brückenansteuerschaltung sowie der zweite Transistor Q2, der dritte Transistor Q3 und der vierte Transistor Q4 mit den drei Phasenleitungen U, V, W des Motors gekoppelt. In der vorliegenden Anmeldung können beispielsweise der zweite Transistor Q2, der dritte Transistor Q3 und der vierte Transistor Q4 Metall-Oxid-Halbleiter-Feldeffekttransistoren (MOSFETs) oder jeder andere Typ von Transistoren sein und als Phasenleitungs-MOSFET-Schalter des Erkennungssystems verwendet werden. Es ist zu beachten, dass die vorliegende Anmeldung keine Einschränkungen hinsichtlich der jeweiligen spezifischen Strukturen und Parameter des zweiten Transistors Q2, des dritten Transistors Q3 und des vierten Transistors Q4 macht.

In einigen Ausführungsbeispielen können der zweite Transistor Q2, der dritte Transistor Q3 und der vierte Transistor Q4 gesperrt werden, wenn der Port PORT1 der Mikrocontrollereinheit MCU in den Low-Pegel-Ausgangszustand konfiguriert ist; und der zweite Transistor Q2, der dritte Transistor Q3 und der vierte Transistor Q4 können durchgeschaltet werden, wenn der Port PORT1 der Mikrocontrollereinheit MCU als hochohmiger Eingangszustand konfiguriert ist.

Wie oben beschrieben, kann das Erkennungssystem für dieses Kurzschlussfehlererkennungssystem einen Initialisierungs-Selbsttest durchführen, wenn der Port PORT1 der Mikrocontrollereinheit MCU in den Low-Pegel-Ausgangszustand konfiguriert ist, wodurch der Ladungspumpen-Spannungsausgangsanschluss CP des Treiber-ICs aktiviert wird und der erste Transistor Q1 leitet; wenn der Port PORT1 als hochohmiger Eingangszustand konfiguriert ist, werden sowohl der Ladungspumpen-Spannungsausgangsanschluss CP als auch der Gate-Ansteuerungs-Spannungsausgangsanschluss GD des Treiber-ICs aktiviert, der erste Transistor Q1 leitet, und der zweite Transistor Q2, der dritte Transistor Q3 und der vierte Transistor Q4 leiten ebenfalls, sodass das Ansteuermodul in den normalen Arbeitszustand übergehen kann, um den Motorbetrieb durch Motoransteuersignale anzusteuern, die von der Dreiphasen-Brückenansteuerschaltung unter Steuerung des PWM-Ansteuersignals erzeugt werden.

In einigen Ausführungsbeispielen kann das Durchführen des Initialisierungs-Selbsttests des Erkennungssystems umfassen: Bestimmen durch das Fehlererkennungsmodul, basierend auf der Phasenspannung, ob bei einem oder mehreren von dem zweiten Transistor Q2, dem dritten Transistor Q3 und dem vierten Transistor Q4 ein Kurzschlussfehler aufgetreten ist. Des Weiteren kann in einigen Ausführungsbeispielen das Bestimmen, ob bei einem oder mehreren von dem zweiten Transistor Q2, dem dritten Transistor Q3 und dem vierten Transistor Q4 ein Kurzschlussfehler aufgetreten ist, umfassen: wenn die Phasenspannung der Phasenleitung, mit der einer oder mehrere beliebige von dem zweiten Transistor Q2, dem dritten Transistor Q3 und dem vierten Transistor Q4 gekoppelt sind, nicht Null ist, beispielsweise wenn die Phasenspannung ein voreingestellter Wert ist, Bestimmen, dass bei dem einen oder den mehreren Transistoren ein Kurzschlussfehler aufgetreten ist.

In einigen Ausführungsbeispielen kann, wie in Fig. 3 gezeigt, das Stromabtastmodul einen ersten Widerstand R1, einen zweiten Widerstand R2 und einen dritten Widerstand R3 umfassen, die dazu dienen, die verschiedenen Phasenströme des Motors jeweils abzutasten. Des Weiteren kann in einigen Ausführungsbeispielen, wie in Fig. 3 gezeigt, das Fehlererkennungsmodul ferner einen vierten Widerstand R4 umfassen, wobei der Port PORT1 der Mikrocontrollereinheit MCU sowie der Gate-Ansteuerungs-Spannungsausgangsanschluss GD des Treiber-ICs über den vierten Widerstand R4 mit der im Erkennungssystem enthaltenen Chip-Stromversorgung Vcc gekoppelt sind. Es ist zu beachten, dass die Widerstandswerte des ersten Widerstands R1, des zweiten Widerstands R2, des dritten Widerstands R3 sowie des vierten Widerstands R4 entsprechend den tatsächlichen Schaltungsdesignanforderungen festgelegt werden können und in der vorliegenden Anmeldung nicht eingeschränkt sind.

Die im Kurzschlussfehlererkennungssystem gemäß den Ausführungsbeispielen der vorliegenden Anmeldung verwendeten Komponenten sind allesamt universelle Motorsteuerungskomponenten, es wurden keine zusätzlichen Komponenten hinzugefügt, die Schaltungsstruktur ist relativ einfach und die Herstellungskosten sind niedrig. Des Weiteren kann das Kurzschlussfehlererkennungssystem gemäß den Ausführungsbeispielen der vorliegenden Anmeldung durch Konfigurieren des Zustands desselben Ports gleichzeitig den Initialisierungs-Selbsttest sowie die normale Steuerung des Motors realisieren, wodurch auch der Softwareaufwand niedrig ist.

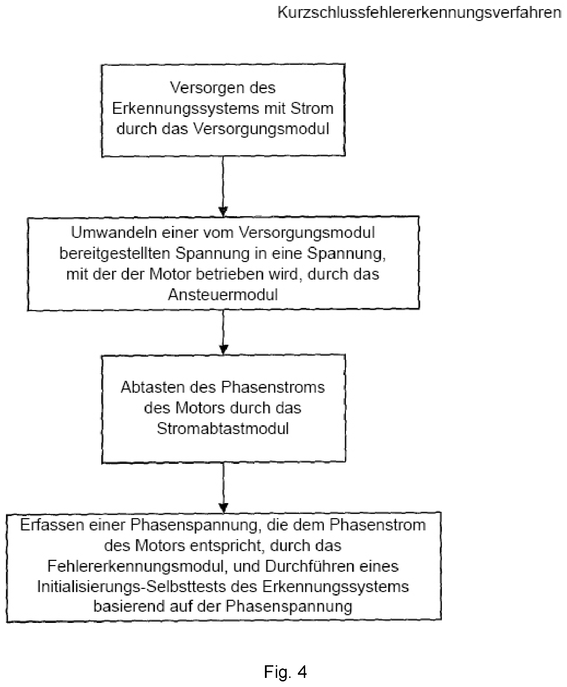

Im Folgenden wird unter Bezugnahme auf Fig. 3 und Fig. 4 ein Kurzschlussfehlererkennungsverfahren gemäß einem Ausführungsbeispiel der vorliegenden Anmeldung beschrieben, wobei Fig. 4 ein schematisches Flussdiagramm des Kurzschlussfehlererkennungsverfahrens gemäß einem Ausführungsbeispiel der vorliegenden Anmeldung zeigt. Dieses Kurzschlussfehlererkennungsverfahren kann in einem Kurzschlussfehlererkennungssystem gemäß einem Ausführungsbeispiel der vorliegenden Anmeldung verwendet werden, insbesondere umfasst dieses Erkennungssystem ein Versorgungsmodul, ein Ansteuermodul, ein Stromabtastmodul und ein Fehlererkennungsmodul. Bezüglich der Details des Versorgungsmoduls, des Ansteuermoduls, des Stromabtastmoduls und des Fehlererkennungsmoduls kann auf die obige Beschreibung des Kurzschlussfehlererkennungssystems verwiesen werden, was hier nicht wiederholt wird.

In einigen Ausführungsbeispielen, wie in Fig. 4 gezeigt, umfasst das Kurzschlussfehlererkennungsverfahren: Versorgen des Erkennungssystems mit Strom durch das Versorgungsmodul; Umwandeln einer vom Versorgungsmodul bereitgestellten Systemspannung in eine Spannung, mit der der Motor betrieben wird, durch das Ansteuermodul; Abtasten des Phasenstroms des Motors durch das Stromabtastmodul; sowie Erfassen einer Phasenspannung, die dem Phasenstrom des Motors entspricht, durch das Fehlererkennungsmodul, und Durchführen eines Initialisierungs-Selbsttests des Erkennungssystems basierend auf der Phasenspannung.

In einigen Ausführungsbeispielen, unter Bezugnahme auf Fig. 3 und Fig. 4, kann das Fehlererkennungsmodul eine Mikrocontrollereinheit MCU umfassen, und das Erkennungsverfahren kann ferner umfassen: Konfigurieren des Zustands des Ports PORT1 der Mikrocontrollereinheit MCU durch das Fehlererkennungsmodul, um den Initialisierungs-Selbsttest des Erkennungssystems durchzuführen, wobei das Konfigurieren des Zustands des Ports PORT1 der Mikrocontrollereinheit MCU das Konfigurieren des Ports PORT1 in einen von einem Low-Pegel-Ausgangszustand und einem hochohmigen Eingangszustand umfasst.

In einigen Ausführungsbeispielen, unter Bezugnahme auf Fig. 3 und Fig. 4, kann das Fehlererkennungsmodul ferner einen Treiber-IC umfassen, und das Durchführen des Initialisierungs-Selbsttests des Erkennungssystems kann umfassen: Konfigurieren des Ports PORT1 der Mikrocontrollereinheit MCU in den Low-Pegel-Ausgangszustand, um den Ladungspumpen-Spannungsausgangsanschluss CP des Treiber-ICs zu aktivieren und den Gate-Ansteuerungs-Spannungsausgangsanschluss GD des Treiber-ICs zu deaktivieren.

In einigen Ausführungsbeispielen kann das Durchführen des Initialisierungs-Selbsttests des Erkennungssystems ferner umfassen: wenn erkannt wird, dass die Phasenspannung Null ist, Konfigurieren des Ports PORT1 der Mikrocontrollereinheit MCU in den hochohmigen Eingangszustand, um sowohl den Ladungspumpen-Spannungsausgangsanschluss CP als auch den Gate-Ansteuerungs-Spannungsausgangsanschluss GD des Treiber-ICs zu aktivieren und in den normalen Betriebsmodus zur Steuerung des Motors überzugehen; und wenn erkannt wird, dass die Phasenspannung nicht Null ist, Bestimmen, dass ein Kurzschlussfehler aufgetreten ist.

In einigen Ausführungsbeispielen, unter Bezugnahme auf Fig. 3 und Fig. 4, kann das Versorgungsmodul eine Systemstromversorgung VBATT und einen ersten Transistor Q1 umfassen, und das Fehlererkennungsmodul und das Ansteuermodul sind über den ersten Transistor Q1 mit der Systemstromversorgung VBATT gekoppelt. Das Erkennungsverfahren kann ferner umfassen: Konfigurieren des Zustands des Ports PORT1 der Mikrocontrollereinheit MCU durch das Fehlererkennungsmodul, um das Leiten und Sperren des ersten Transistors Q1 zu steuern. Optional kann in einigen Ausführungsbeispielen der erste Transistor Q1 leiten, wenn der Port PORT1 in den Low-Pegel-Ausgangszustand oder als hochohmiger Eingangszustand konfiguriert ist.

In einigen Ausführungsbeispielen, unter Bezugnahme auf Fig. 3 und Fig. 4, kann das Ansteuermodul eine Dreiphasen-Brückenansteuerschaltung sowie einen zweiten Transistor Q2, einen dritten Transistor Q3 und einen vierten Transistor Q4 umfassen. Bezüglich der Details dieser Komponenten kann auf die obige Beschreibung des Ansteuermoduls im Fehlererkennungssystem verwiesen werden, was hier nicht wiederholt wird. In einigen Ausführungsbeispielen werden der zweite Transistor Q2, der dritte Transistor Q3 und der vierte Transistor Q4 gesperrt, wenn der Port PORT1 der Mikrocontrollereinheit MCU in den Low-Pegel-Ausgangszustand konfiguriert ist; und der zweite Transistor Q2, der dritte Transistor Q3 und der vierte Transistor Q4 werden durchgeschaltet, wenn der Port PORT1 der Mikrocontrollereinheit MCU als hochohmiger Eingangszustand konfiguriert ist.

Daher kann in diesem Kurzschlussfehlererkennungsverfahren, wenn der Port PORT1 der Mikrocontrollereinheit MCU in den Low-Pegel-Ausgangszustand konfiguriert ist, der Ladungspumpen-Spannungsausgangsanschluss CP des Treiber-ICs aktiviert wird und der erste Transistor Q1 leitet, der Initialisierungs-Selbsttest des Erkennungssystems durchgeführt werden; wenn der Port PORT1 als hochohmiger Eingangszustand konfiguriert ist, werden sowohl der Ladungspumpen-Spannungsausgangsanschluss CP als auch der Gate-Ansteuerungs-Spannungsausgangsanschluss GD des Treiber-ICs aktiviert, der erste Transistor Q1 leitet, und der zweite Transistor Q2, der dritte Transistor Q3 und der vierte Transistor Q4 leiten ebenfalls, sodass das Ansteuermodul in den normalen Arbeitszustand übergehen kann, um den Motorbetrieb durch Motoransteuersignale anzusteuern, die von der Dreiphasen-Brückenansteuerschaltung unter Steuerung des PWM-Ansteuersignals erzeugt werden.

In einigen Ausführungsbeispielen kann das Durchführen des Initialisierungs-Selbsttests des Erkennungssystems umfassen: Bestimmen durch das Fehlererkennungsmodul, basierend auf der Phasenspannung, ob bei einem oder mehreren von dem zweiten Transistor Q2, dem dritten Transistor Q3 und dem vierten Transistor Q4 ein Kurzschlussfehler aufgetreten ist. Des Weiteren kann in einigen Ausführungsbeispielen das Bestimmen, ob bei einem oder mehreren von dem zweiten Transistor Q2, dem dritten Transistor Q3 und dem vierten Transistor Q4 ein Kurzschlussfehler aufgetreten ist, umfassen: wenn die Phasenspannung der Phasenleitung, mit der einer oder mehrere beliebige von dem zweiten Transistor Q2, dem dritten Transistor Q3 und dem vierten Transistor Q4 gekoppelt sind, nicht Null ist, beispielsweise wenn die Phasenspannung ein voreingestellter Wert ist, Bestimmen, dass bei dem einen oder den mehreren Transistoren ein Kurzschlussfehler aufgetreten ist.

Die im Kurzschlussfehlererkennungsverfahren gemäß den Ausführungsbeispielen der vorliegenden Anmeldung verwendeten Komponenten sind allesamt universelle Motorsteuerungskomponenten, es wurden keine zusätzlichen Komponenten hinzugefügt, und die Schaltungsstruktur ist relativ einfach. Des Weiteren kann das Kurzschlussfehlererkennungsverfahren gemäß den Ausführungsbeispielen der vorliegenden Anmeldung durch Konfigurieren des Zustands desselben Ports gleichzeitig den Initialisierungs-Selbsttest sowie die normale Steuerung des Motors realisieren, wodurch auch der Softwareaufwand niedrig ist. Obwohl die vorliegende Anmeldung die Schritte des oben beschriebenen Kurzschlussfehlererkennungsverfahrens in einer bestimmten Reihenfolge gezeigt und beschrieben hat, ist es verständlich, dass diese Schritte in einer anderen Reihenfolge als der in Fig. 4 gezeigten ausgeführt werden können.

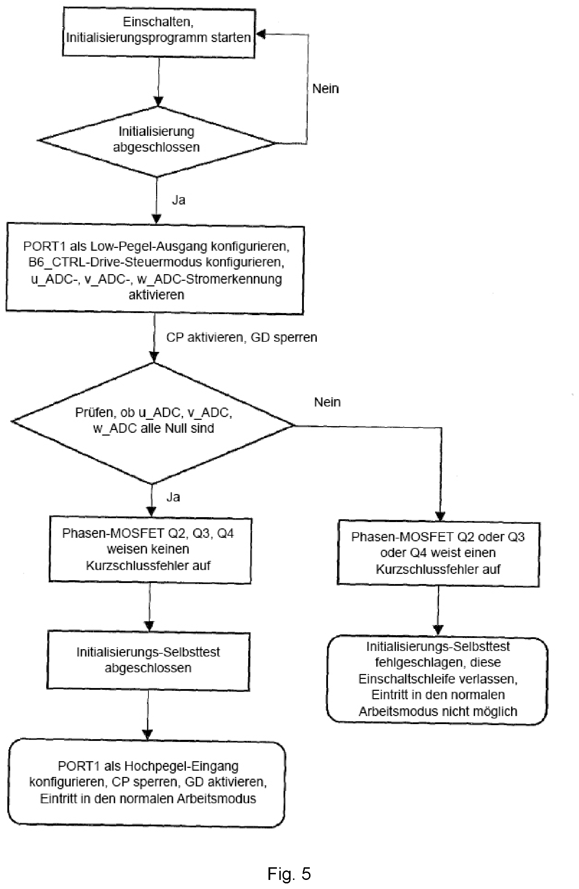

Bezugnehmend auf Fig. 5 wird ein weiteres schematisches Flussdiagramm eines Kurzschlussfehlererkennungsverfahrens gemäß einem Ausführungsbeispiel der vorliegenden Anmeldung gezeigt. Dieses Kurzschlussfehlererkennungsverfahren kann in einem Kurzschlussfehlererkennungssystem gemäß einem Ausführungsbeispiel der vorliegenden Anmeldung verwendet werden, insbesondere umfasst dieses Erkennungssystem ein Versorgungsmodul, ein Ansteuermodul, ein Stromabtastmodul und ein Fehlererkennungsmodul. Bezüglich der Details des Versorgungsmoduls, des Ansteuermoduls, des Stromabtastmoduls und des Fehlererkennungsmoduls kann auf die obige Beschreibung des Kurzschlussfehlererkennungssystems verwiesen werden, was hier nicht wiederholt wird.

Wie in Fig. 5 gezeigt, wird, wenn das übergeordnete System (z. B. Fahrzeugsystem, Motorsystem usw.) aufgeweckt wird, um ein Einschalt-Initialisierungsprogramm auszuführen, das Abschluss-Flag dieses Einschalt-Initialisierungsprogramms erkannt. Wenn die Einschalt-Initialisierung nicht abgeschlossen ist, wird der Initialisierungszyklusprozess erneut durchlaufen; wenn die Einschalt-Initialisierung abgeschlossen ist, ist die grundlegende Funktionsinitialisierungskonfiguration des übergeordneten Systems abgeschlossen und die Funktionskonfiguration der Kurzschlussfehlererkennung kann ausgeführt werden.

In einigen Ausführungsbeispielen kann, wie in Fig. 5 gezeigt, diese Funktionskonfiguration der Kurzschlussfehlererkennung das Konfigurieren des Ports PORT1 der Mikrocontrollereinheit MCU in den Low-Pegel-Ausgangszustand, das Konfigurieren des Ansteuerungssteuerungsmodus des Ansteuersignals B6_CTRL sowie das Aktivieren der Stromerkennungsfunktion der ADC-Eingangsports u_ADC, v_ADC, w_ADC der Mikrocontrollereinheit MCU umfassen.

Wie oben beschrieben, wenn der Port PORT1 der Mikrocontrollereinheit MCU in den Low-Pegel-Ausgangszustand konfiguriert ist, wird der Ladungspumpen-Spannungsausgangsanschluss CP des Treiber-ICs aktiviert und der Gate-Ansteuerungs-Spannungsausgangsanschluss GD deaktiviert. Zu diesem Zeitpunkt leitet der erste Transistor Q1 des Versorgungsmoduls, während der zweite Transistor Q2, der dritte Transistor Q3 und der vierte Transistor Q4 des Ansteuermoduls gesperrt sind. Die Dreiphasen-Brückenansteuerschaltung im Ansteuermodul steuert das Leiten/Sperren der Schalter in ihren Brückenarmen basierend auf dem eingegebenen PWM-Ansteuersignal, um Motoransteuersignale zu erzeugen. In dem Zustand, in dem der zweite Transistor Q2, der dritte Transistor Q3 und der vierte Transistor Q4 gesperrt sind, wird auf keiner der drei Phasenleitungen U, V, W des Motors ein Stromkreis gebildet.

In einigen Ausführungsbeispielen wird, nachdem die Funktionskonfiguration der Kurzschlussfehlererkennung abgeschlossen ist, erfasst, ob die Abtastspannungssignale der ADC-Eingangsports u_ADC, v_ADC, w_ADC der Mikrocontrollereinheit MCU Null sind.

Wenn erkannt wird, dass die Abtastspannungssignale der ADC-Eingangsports u_ADC, v_ADC, w_ADC alle Null sind, bedeutet dies, dass bei dem zweiten Transistor Q2, dem dritten Transistor Q3 und dem vierten Transistor Q4 kein Kurzschlussfehler aufgetreten ist, und der Initialisierungs-Selbsttest der Kurzschlussfehlererkennung ist abgeschlossen. Anschließend wird der Port PORT1 der Mikrocontrollereinheit MCU als hochohmiger Eingangszustand konfiguriert, dieser Port PORT1 wird über den Pull-up-Widerstand R4 als High-Pegel konfiguriert, der Ladungspumpen-Spannungsausgangsanschluss CP des Treiber-ICs wird aktiviert, und der Gate-Ansteuerungs-Spannungsausgangsanschluss GD des Treiber-ICs wird ebenfalls über den Pull-up-Widerstand R4 als High-Pegel konfiguriert und aktiviert. Zu diesem Zeitpunkt leitet der erste Transistor Q1 des Versorgungsmoduls und der zweite Transistor Q2, der dritte Transistor Q3 und der vierte Transistor Q4 des Ansteuermoduls leiten ebenfalls, wodurch in den normalen Betriebsmodus zur Steuerung des Motors übergegangen wird, um den Motorbetrieb durch Motoransteuersignale anzusteuern, die von der Dreiphasen-Brückenansteuerschaltung unter Steuerung des PWM-Ansteuersignals erzeugt werden.

Wenn erkannt wird, dass eines oder mehrere der Abtastspannungssignale der ADC-Eingangsports u_ADC, v_ADC, w_ADC nicht Null sind, bedeutet dies, dass auf der Phasenleitung, die dem nicht-Null-Abtastspannungssignal entspricht, ein unerwarteter Stromkreis gebildet wurde, d. h., dass bei dem oder den Transistoren von dem zweiten Transistor Q2, dem dritten Transistor Q3 und dem vierten Transistor Q4, die dem Nicht-Null-Abtastspannungssignal entsprechen, ein Kurzschlussfehler aufgetreten ist. In diesem Fall schlägt der Initialisierungs-Selbsttest der Kurzschlussfehlererkennung fehl, dieser Einschaltzyklus wird beendet, und es kann nicht in den normalen Betriebsmodus zur Steuerung des Motors übergegangen werden.

Des Weiteren kann in einigen Implementierungen auch nach dem Übergang in den normalen Betriebsmodus zur Steuerung des Motors weiterhin erfasst werden, ob die Abtastspannungssignale der ADC-Eingangsports u_ADC, v_ADC, w_ADC der Mikrocontrollereinheit MCU Null sind, um zu bestimmen, ob bei dem zweiten Transistor Q2, dem dritten Transistor Q3 und dem vierten Transistor Q4 des Ansteuermoduls ein Unterbrechungsfehler aufgetreten ist.

Das Kurzschlussfehlererkennungssystem und -verfahren gemäß den Ausführungsbeispielen der vorliegenden Anmeldung können Kurzschlussfehler von Phasenleitungs-MOSFET-Schaltern erkennen, ohne zusätzliche Schaltungskosten und zusätzlichen Softwareaufwand zu verursachen, einen Initialisierungs-Selbsttest des Erkennungssystems durchführen und in den normalen Betriebsmodus zur Steuerung des Motors übergehen, während gleichzeitig auch die Steuerung der High-Side-MOSFET-Schalter realisiert werden kann. Beispielsweise sind die im Kurzschlussfehlererkennungssystem und -verfahren gemäß den Ausführungsbeispielen der vorliegenden Anmeldung verwendeten Komponenten allesamt universelle Motorsteuerungskomponenten, es wurden keine zusätzlichen Komponenten hinzugefügt, die Schaltungsstruktur ist relativ einfach und die Herstellungskosten sind niedrig. Des Weiteren können dieses Kurzschlussfehlererkennungssystem und -verfahren durch Konfigurieren des Zustands desselben Ports gleichzeitig den Initialisierungs-Selbsttest sowie die normale Steuerung des Motors realisieren, wodurch auch der Softwareaufwand niedrig ist.

Fachleute auf diesem Gebiet werden verstehen, dass die vorliegende Anmeldung nicht auf die oben beschriebenen und in den Zeichnungen gezeigten spezifischen Strukturen und Schritte beschränkt ist. Der Kürze halber wurde hier auf eine Beschreibung bekannter Strukturen und Verfahren verzichtet. In den obigen Ausführungsbeispielen wurden mehrere spezifische Schritte als Beispiele beschrieben und gezeigt. Das Verfahren der vorliegenden Anmeldung ist jedoch nicht auf die beschriebenen und gezeigten spezifischen Schritte beschränkt, und Fachleute auf diesem Gebiet können verschiedene Änderungen, Modifikationen und Ergänzungen an den Ausführungsbeispielen der vorliegenden Anmeldung vornehmen oder die Reihenfolge zwischen den Schritten ändern, ohne vom Schutzumfang der vorliegenden Anmeldung abzuweichen.

Die in den obigen Strukturblockdiagrammen gezeigten Funktionsblöcke können als Hardware, Software, Firmware oder eine Kombination davon implementiert werden. Bei einer Implementierung als Hardware können die Funktionsblöcke beispielsweise eine elektronische Schaltung, eine anwendungsspezifische integrierte Schaltung (ASIC), geeignete Firmware, ein Plug-in, eine Funktionskarte usw. sein. Bei einer Implementierung als Software sind die Elemente der vorliegenden Anmeldung Programme oder Codeabschnitte, die zur Ausführung der erforderlichen Aufgaben verwendet werden. Diese Programme oder Codeabschnitte können auf einem maschinenlesbaren Medium gespeichert oder über ein Datensignal, das in einer Trägerwelle enthalten ist, auf einem Übertragungsmedium oder einer Kommunikationsverbindung übertragen werden. Das maschinenlesbare Medium kann jedes Medium umfassen, das Informationen speichern oder übertragen kann. Beispiele für maschinenlesbare Medien umfassen elektronische Schaltungen, Halbleiterspeicherbauelemente, ROM, Flash-Speicher, löschbaren ROM (EROM), Disketten, CD-ROM, optische Discs, Festplatten, faseroptische Medien, Hochfrequenz (RF)-Verbindungen usw. Die Codeabschnitte können über ein Computernetzwerk wie das Internet, Intranet usw. heruntergeladen werden.

Die obige Offenbarung stellt nur einige spezifische Ausführungsformen der vorliegenden Anmeldung dar. Fachleute auf diesem Gebiet können verstehen, dass aus Gründen der Bequemlichkeit und Kürze der Beschreibung auf die entsprechenden Prozesse in den Verfahrensausführungsbeispielen für die spezifischen Arbeitsprozesse der oben genannten Systeme, Module und Einheiten verwiesen werden kann, was hier nicht weiter ausgeführt wird. Des Weiteren ist es verständlich, dass der Schutzumfang der vorliegenden Anmeldung nicht darauf beschränkt ist. Fachleute auf diesem Gebiet können im Rahmen der in der vorliegenden Anmeldung offenbarten Technik verschiedene äquivalente Modifikationen oder Ersetzungen vornehmen, und diese äquivalenten Modifikationen oder Ersetzungen sind alle im Schutzumfang der vorliegenden Anmeldung enthalten.

## Patentansprüche

1. Kurzschlussfehlererkennungssystem, umfassend:
ein Versorgungsmodul, das dazu dient, das Erkennungssystem mit Strom zu versorgen;
ein Ansteuermodul, das mit dem Versorgungsmodul und einem Motor gekoppelt ist und dazu dient, eine vom Versorgungsmodul bereitgestellte Systemspannung in eine Spannung umzuwandeln, mit der der Motor betrieben wird;
ein Stromabtastmodul, das mit dem Ansteuermodul gekoppelt ist und dazu dient, den Phasenstrom des Motors abzutasten; sowie
ein Fehlererkennungsmodul, das mit dem Versorgungsmodul und dem Stromabtastmodul gekoppelt ist, wobei das Fehlererkennungsmodul dazu konfiguriert ist: eine Phasenspannung zu erfassen, die dem Phasenstrom des Motors entspricht, und basierend auf der Phasenspannung einen Initialisierungs-Selbsttest des Erkennungssystems durchzuführen.

2. Erkennungssystem nach Anspruch 1, wobei das Fehlererkennungsmodul eine Mikrocontrollereinheit umfasst und ferner dazu konfiguriert ist: den Initialisierungs-Selbsttest des Erkennungssystems durch Konfigurieren des Zustands eines Ports der Mikrocontrollereinheit durchzuführen.

3. Erkennungssystem nach Anspruch 2, wobei das Konfigurieren des Zustands des Ports der Mikrocontrollereinheit umfasst: Konfigurieren des Ports in einen von einem Low-Pegel-Ausgangszustand und einem hochohmigen Eingangszustand.

4. Erkennungssystem nach Anspruch 2 oder 3, wobei das Fehlererkennungsmodul ferner einen Treiber-IC umfasst, und die Mikrocontrollereinheit dazu konfiguriert ist: über den Port mit dem Treiber-IC gekoppelt zu sein und über den Port den Ausgangszustand des Treiber-ICs zu steuern.

5. Erkennungssystem nach Anspruch 4, wobei der Treiber-IC einen Ladungspumpen-Spannungsausgangsanschluss und einen Gate-Ansteuerungs-Spannungsausgangsanschluss umfasst, und das Steuern des Ausgangszustands des Treiber-ICs über den Port umfasst:
wenn der Port in den Low-Pegel-Ausgangszustand konfiguriert ist, Aktivieren des Ladungspumpen-Spannungsausgangsanschlusses und Deaktivieren des Gate-Ansteuerungs-Spannungsausgangsanschlusses; sowie
wenn der Port in den hochohmigen Eingangszustand konfiguriert ist, Aktivieren sowohl des Ladungspumpen-Spannungsausgangsanschlusses als auch des Gate-Ansteuerungs-Spannungsausgangsanschlusses.

6. Erkennungssystem nach Anspruch 2 oder 3, wobei das Versorgungsmodul eine Systemstromversorgung und einen ersten Transistor umfasst, und das Fehlererkennungsmodul und das Ansteuermodul über den ersten Transistor mit der Systemstromversorgung gekoppelt sind.

7. Erkennungssystem nach Anspruch 6, wobei das Fehlererkennungsmodul ferner dazu konfiguriert ist: durch Konfigurieren des Zustands des Ports der Mikrocontrollereinheit das Leiten und Sperren des ersten Transistors zu steuern.

8. Erkennungssystem nach Anspruch 2 oder 3, wobei das Ansteuermodul einen zweiten Transistor, einen dritten Transistor und einen vierten Transistor umfasst, und wobei der zweite Transistor, der dritte Transistor und der vierte Transistor jeweils mit verschiedenen Phasenleitungen des Motors gekoppelt sind.

9. Erkennungssystem nach Anspruch 8, wobei:
wenn der Port der Mikrocontrollereinheit in den Low-Pegel-Ausgangszustand konfiguriert ist, der zweite Transistor, der dritte Transistor und der vierte Transistor gesperrt werden; sowie
wenn der Port der Mikrocontrollereinheit in den hochohmigen Eingangszustand konfiguriert ist, der zweite Transistor, der dritte Transistor und der vierte Transistor durchgeschaltet werden.

10. Erkennungssystem nach Anspruch 8, wobei das Durchführen des Initialisierungs-Selbsttests des Erkennungssystems umfasst:
Bestimmen durch das Fehlererkennungsmodul, basierend auf der Phasenspannung, ob bei einem oder mehreren von dem zweiten Transistor, dem dritten Transistor und dem vierten Transistor ein Kurzschlussfehler aufgetreten ist.

11. Erkennungssystem nach Anspruch 10, wobei das Bestimmen, ob bei einem oder mehreren von dem zweiten Transistor, dem dritten Transistor und dem vierten Transistor ein Kurzschlussfehler aufgetreten ist, umfasst:
wenn die Phasenspannung der Phasenleitung, mit der einer oder mehrere beliebige von dem zweiten Transistor, dem dritten Transistor und dem vierten Transistor gekoppelt sind, nicht Null ist, Bestimmen, dass bei dem einen oder den mehreren Transistoren ein Kurzschlussfehler aufgetreten ist.

12. Erkennungssystem nach einem der Ansprüche 1 bis 3, wobei das Stromabtastmodul umfasst: einen ersten Widerstand, einen zweiten Widerstand und einen dritten Widerstand, die dazu dienen, die verschiedenen Phasenströme des Motors abzutasten.

13. Erkennungssystem nach Anspruch 5, wobei das Fehlererkennungsmodul ferner einen vierten Widerstand umfasst, wobei der Port der Mikrocontrollereinheit sowie der Gate-Ansteuerungs-Spannungsausgangsanschluss des Treiber-ICs über den vierten Widerstand mit einer im Erkennungssystem enthaltenen Chip-Stromversorgung gekoppelt sind.

14. Kurzschlussfehlererkennungsverfahren für ein Kurzschlussfehlererkennungssystem, wobei das Erkennungssystem ein Versorgungsmodul, ein Ansteuermodul, ein Stromabtastmodul und ein Fehlererkennungsmodul umfasst, wobei das Erkennungsverfahren umfasst: Versorgen des Erkennungssystems mit Strom durch das Versorgungsmodul; Umwandeln einer vom Versorgungsmodul bereitgestellten Systemspannung in eine Spannung, mit der der Motor betrieben wird, durch das Ansteuermodul; Abtasten des Phasenstroms des Motors durch das Stromabtastmodul; sowie Erfassen einer Phasenspannung, die dem Phasenstrom des Motors entspricht, durch das Fehlererkennungsmodul, und Durchführen eines Initialisierungs-Selbsttests des Erkennungssystems basierend auf der Phasenspannung.

15. Erkennungsverfahren nach Anspruch 14, wobei das Fehlererkennungsmodul eine Mikrocontrollereinheit umfasst, und das Erkennungsverfahren ferner umfasst:
Konfigurieren des Zustands eines Ports der Mikrocontrollereinheit durch das Fehlererkennungsmodul, um den Initialisierungs-Selbsttest des Erkennungssystems durchzuführen; und
wobei das Konfigurieren des Zustands des Ports der Mikrocontrollereinheit das Konfigurieren des Ports in einen der Zustände eines Low-Pegel-Ausgangszustands und eines hochohmigen Eingangszustands umfasst.

16. Erkennungsverfahren nach Anspruch 15, wobei das Fehlererkennungsmodul ferner einen Treiber-IC umfasst, und das Durchführen des Initialisierungs-Selbsttests des Erkennungssystems umfasst:
Konfigurieren des Ports der Mikrocontrollereinheit in den Low-Pegel-Ausgangszustand, um den Ladungspumpen-Spannungsausgangsanschluss des Treiber-ICs zu aktivieren und den Gate-Ansteuerungs-Spannungsausgangsanschluss des Treiber-ICs zu deaktivieren.

17. Erkennungsverfahren nach Anspruch 16, wobei das Durchführen des Initialisierungs-Selbsttests des Erkennungssystems ferner umfasst:
wenn erkannt wird, dass die Phasenspannung Null ist, Konfigurieren des Ports der Mikrocontrollereinheit in den hochohmigen Eingangszustand, um sowohl den Ladungspumpen-Spannungsausgangsanschluss als auch den Gate-Ansteuerungs-Spannungsausgangsanschluss des Treiber-ICs zu aktivieren und in den normalen Betriebsmodus zur Steuerung des Motors überzugehen; sowie
wenn erkannt wird, dass die Phasenspannung nicht Null ist, Bestimmen, dass ein Kurzschlussfehler aufgetreten ist.

18. Erkennungsverfahren nach Anspruch 15, wobei das Versorgungsmodul einen ersten Transistor umfasst, und das Erkennungsverfahren ferner umfasst: Konfigurieren des Zustands des Ports der Mikrocontrollereinheit durch das Fehlererkennungsmodul, um das Leiten und Sperren des ersten Transistors zu steuern.

19. Erkennungsverfahren nach Anspruch 15, wobei das Ansteuermodul einen zweiten Transistor, einen dritten Transistor und einen vierten Transistor umfasst, und wobei der zweite Transistor, der dritte Transistor und der vierte Transistor jeweils mit verschiedenen Phasenleitungen des Motors gekoppelt sind.

20. Erkennungsverfahren nach Anspruch 19, wobei:
wenn der Port der Mikrocontrollereinheit in den Low-Pegel-Ausgangszustand konfiguriert ist, der zweite Transistor, der dritte Transistor und der vierte Transistor gesperrt werden; sowie
wenn der Port der Mikrocontrollereinheit als hochohmiger Eingangszustand konfiguriert ist, der zweite Transistor, der dritte Transistor und der vierte Transistor durchgeschaltet werden.

21. Erkennungsverfahren nach Anspruch 19 oder 20, wobei das Durchführen des Initialisierungs-Selbsttests des Erkennungssystems umfasst:
Bestimmen durch das Fehlererkennungsmodul, basierend auf der Phasenspannung, ob bei einem oder mehreren von dem zweiten Transistor, dem dritten Transistor und dem vierten Transistor ein Kurzschlussfehler aufgetreten ist.

22. Erkennungsverfahren nach Anspruch 21, wobei das Bestimmen, ob bei einem oder mehreren von dem zweiten Transistor, dem dritten Transistor und dem vierten Transistor ein Kurzschlussfehler aufgetreten ist, umfasst:
wenn die Phasenspannung der Phasenleitung, mit der einer oder mehrere beliebige von dem zweiten Transistor, dem dritten Transistor und dem vierten Transistor gekoppelt sind, nicht Null ist, Bestimmen, dass bei dem einen oder den mehreren Transistoren ein Kurzschlussfehler aufgetreten ist.
